(19) Europäisches Patentamt
European Patent Office
Office européen des brevets

(11) **EP 0 616 230 B1**

(12) **EUROPÄISCHE PATENTSCHRIFT**

(45) Veröffentlichungstag und Bekanntmachung des Hinweises auf die Patenterteilung:
**05.08.1998 Patentblatt 1998/32**

(51) Int Cl.6: **G01R 33/38**, H01F 7/02

(21) Anmeldenummer: **94103114.8**

(22) Anmeldetag: **02.03.1994**

(54) **Homogenfeldmagnet mit über Korrekturluftspalte beabstandeten Polplatteneinrichtungen seiner Polschuhe**

Homogeneous field magnet with pole plate spaced by correction air-gap for each pole shoe

Aimant pour champ homogène avec un arrangement de disques polaires séparés par des espaces d'air de correction pour chaque pièce polaire

(84) Benannte Vertragsstaaten:
**DE FR GB IT**

(30) Priorität: **15.03.1993 DE 4308208**

(43) Veröffentlichungstag der Anmeldung:
**21.09.1994 Patentblatt 1994/38**

(73) Patentinhaber: **SIEMENS AKTIENGESELLSCHAFT 80333 München (DE)**

(72) Erfinder:
• **Ries, Günter, Dr. D-91056 Erlangen (DE)**
• **Siebold, Horst, Dr. D-91090 Effeltrich (DE)**

(56) Entgegenhaltungen:
EP-A- 0 170 318    EP-A- 0 284 439
EP-A- 0 488 015    DE-A- 3 737 133
US-A- 4 675 609    US-A- 5 278 534

• PATENT ABSTRACTS OF JAPAN vol. 11, no. 36 (E-477) (2483) 3. Februar 1987 & JP-A-61 203 605 (FUJI ELECTRIC CO. LTD.) 9. September 1986
• IEEE TRANSACTIONS ON MAGNETICS, Bd.28, Nr.1, 1. Januar 1992, NEW YORK US Seiten 931 - 934 M.G. ABELE ET AL. 'FIELD COMPUTATION IN PERMANENT MAGNETS'

## Beschreibung

Die Erfindung bezieht sich auf einen Homogenfeldmagneten mit einem den magnetischen Fluß führenden Joch und zwei gegenüberliegenden Polschuhen, zwischen denen ein Nutzvolumen mit einem Magnetfeld hoher Homogenität ausgebildet ist, wobei jeder Polschuh mit einer Polplatteneinrichtung versehen ist, welche gegenüber einem dem Joch zugewandten Basisteil des jeweiligen Polschuhs über einen schmalen Korrekturluftspalt beabstandet ist und wenigstens zwei zueinander parallele Polplattenelemente aus unterschiedlichen Materialien enthält. Ein entsprechender Homogenfeldmagnet ist z.B. aus der EP 0 488 015 Al zu entnehmen.

Homogenfeldmagnete sind insbesondere zur Erzeugung magnetischer Grundfelder in Anlagen zur Kernspintomographie (Nuclear-Magnetic-Resonance-Tomography, -Imaging oder -Spectroscopy) erforderlich. Das Magnetfeld derartiger Grundfeldmagnete muß dabei in einem Abbildungs- bzw. Untersuchungsbereich (Nutzvolumen) hinreichend homogen sein und dort eine vorbestimmte magnetische Induktion $B_0$ erzeugen. Dabei werden für magnetische Induktionen $B_0 > 0,5$ T im allgemeinen supraleitende Spulensysteme vorgesehen. Demgegenüber sind geringere magnetische Induktionen $B_0 < 0,5$ T auch mit normalleitenden Spulen oder Permanentmagneten zu erzeugen. Letztere Magnete sind vielfach als sogenannte Polschuhmagnete mit einem Magnetjoch in Form eines "C" oder "H" ausgebildet. Zwischen den Polflächen ihrer gegenüberliegenden Polschuhe liegt dann das Nutzvolumen mit der geforderten Feldhomogenität. Insbesondere für die Anforderungen der Kernspintomographie ist wegen der unvermeidlichen Herstellungstoleranzen die anfänglich erreichbare Feldhomogenität im Nutzvolumen nicht ausreichend. Es muß vielmehr am fertigen Magneten eine Korrekturmöglichkeit bestehen, um so durch eine abwechselnde Folge von Feldmessungen und Feldkorrekturen den Feldfehler sukzessive verringern zu können (sogenannte "Shim-Prozedur").

Aus der genannten EP-A geht ein Polschuhmagnet hervor, welcher mechanische Feldkorrekturmöglichkeiten aufweist. Hierzu sind seine Polschuhe im Bereich ihrer Polflächen aus justierbare Polplatteneinrichtungen gestaltet. Außerdem können die dem Nutzvolumen zugewandten Oberflächen der Polschuhe so profiliert sein, daß insbesondere Randeffekte, welche die Homogenität beeinflussen, kompensiert werden.

Um derartige Polplatteneinrichtungen gegenseitig hinreichend exakt ausrichten und Feldfehler korrigieren zu können, ist bei dem bekannten Homogenfeldmagneten jede der Polplatteneinrichtungen nicht unmittelbar an dem einen magnetischen Fluß führenden Magnetjoch befestigt. Vielmehr ist jede Polplatteneinrichtung gegenüber einem dem Joch zugewandten Basisteil des Polschuhes über einen schmalen Korrekturluftspalt beabstandet, wobei sie mittels besonderer Stellvorrichtungen kipp- und/oder biegbar ausgebildet ist. Der Luftspalt wirkt dabei als magnetischer Serienwiderstand feldhomogenisierend, indem er Flußdichteinhomogenitäten in flußführenden Teilen des Polschuhs beim Übertritt in die jeweilige Polplatteneinrichtung ausgleicht.

Gemäß einer besonderen Ausführungsform des bekannten Homogenfeldmagneten kann jede seiner Polplatteneinrichtungen auch durch einen stapelartigen Aufbau aus zwei etwa gleichdicken, schichtartigen Polplattenelementen gebildet werden, wobei für diese Elemente unterschiedliche weichmagnetische Materialien gewählt sind. Das erste, dem Korrekturluftspalt zugewandte Polplattenelement läßt sich z.B. aus mindestens einem Elektroblech aus einer Fe-Si-Legierung erstellen, wobei eine hinreichende Flexibilität des Elementes zu gewährleisten ist. Demgegenüber kann das zweite, dem Nutzvolumen zugewandte Polplattenelement beispielsweise aus einem weichmagnetischen Ferrit oder aus einem kunststoffgebundenen Eisenpulver bestehen. Bei einer relativen Permeabiiität

$$\mu_r \left(= \frac{\mu}{\mu_o} = \frac{1}{\mu_o} \cdot \frac{B}{H}\right)$$

von etwa 1000 und einer Flußtragfähigkeit $B_{max}$ von etwa 0,4 T bis 0,5 T des Materials dieser zweiten Schicht weist dieses Material vorteilhaft nur eine geringe elektrische Leitfähigkeit auf. Die erste Schicht soll demgegenüber für eine gute Grundfeldhomogenität sorgen. Hierzu besteht sie aus einem Material mit einer relativen Permeabilität $\mu_r$ zwischen 1000 und 5000 bei zugleich hoher Flußtragfähigkeit $B_{max}$ von etwa 1,6 T.

Derartige Platteneinrichtungen tragen auch einen von gepulsten Gradientenspulen erzeugten magnetischen Fluß. Es zeigt sich dann aber, daß eine magnetische Hysterese des Plattenmaterials zu Restfeldern nach einem Gradientenpuls und zu einem nicht-linearen Strom-Feld-Zusammenhang führt. Hierdurch kann die Bildgüte bekannter bildgebender Verfahren wie z.B. des als "Turbo-Spin-Echo" bezeichneten Verfahrens beeinträchtigt werden. Das Auftreten von Hystereseerscheinungen ist auch eine Ursache von Fehlern im magnetischen Grundfeld. Je nach dem, ob ein Betriebsstrom vorhandener Erregerspulen von niedrigeren oder höheren Werten aus erreicht wird, ergibt sich nämlich ein anderes Spektrum der Feldfehler. Diese Tatsache erschwert eine Shim-Prozedur zur Einstellung einer optimalen Grundfeldhomogenität.

Aufgabe der vorliegenden Erfindung ist es, bei einem Homogenfeldmagneten mit den eingangs genannten Merkmalen diese auf eine Hysterese zurückzuführenden Fehler auf ein unschädliches Maß zu verringern.

Diese Aufgabe wird erfindungsgemäß dadurch gelöst, daß die Polplattenelemente gegenseitig durch einen Spalt vorbestimmter Weite beabstandet sind und daß an jedem Polschuh das dem Basisteil zugewandte Polplattenelement aus einem Material besteht, dessen relative Permeabilität mindestens um einen Faktor 5 geringer ist als die relative Permeabilität des Materials des dem Nutzvolumen zugewandten Polplattenelements, die mindestens 10000 beträgt.

Die mit dieser Ausgestaltung des Homogenfeldmagneten verbundenen Vorteile sind insbesondere darin zu sehen, daß das hochpermeable Material des dem Nutzvolumen zugewandten Polplattenelementes nur eine geringe Hystereses zeigt. Dieses Polplattenelement trägt im wesentlichen den magnetischen Gradientenfluß, der folglich nur in entsprechend geringem Maße von Restfehlern nach einem Gradientenpuls beeinflußt wird. Demgegenüber übernimmt die Radialflußverteilung des magnetischen Grundfeldes im wesentlichen das dem Basisteil des Polschuhs zugewandte Polplattenelement. In diesem Element spielen Hystereseeffekte nur eine nebensächliche Rolle. Zwischen beiden Polplattenelementen liegt der Spalt als eine magnetische Entkopplungseinrichtung. Dieser Spalt verhindert, daß der radiale Fluß in dem dem Basisteil zugewandten Polplattenelement in das hochpermeable Material des parallelliegenden Plattenelementes übertreten und dieses magnetisch sättigen kann. Deshalb können für diese Polplattenelemente vorteilhaft bekannte hochpermeable Materialien verwendet werden, die eine vergleichsweise geringere magnetische Sättigungsinduktion $B_s$ als die Materialien der dem Basisteil zugewandten Polplattenelemente haben.

Weitere vorteilhafte Ausgestaltungen des erfindungsgemäßen Homogenfeldmagneten gehen aus den abhängigen Ansprüchen hervor.

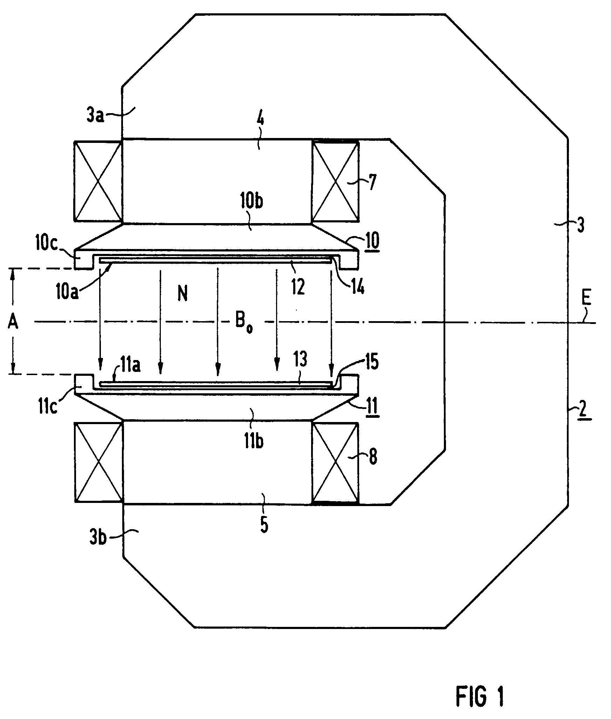

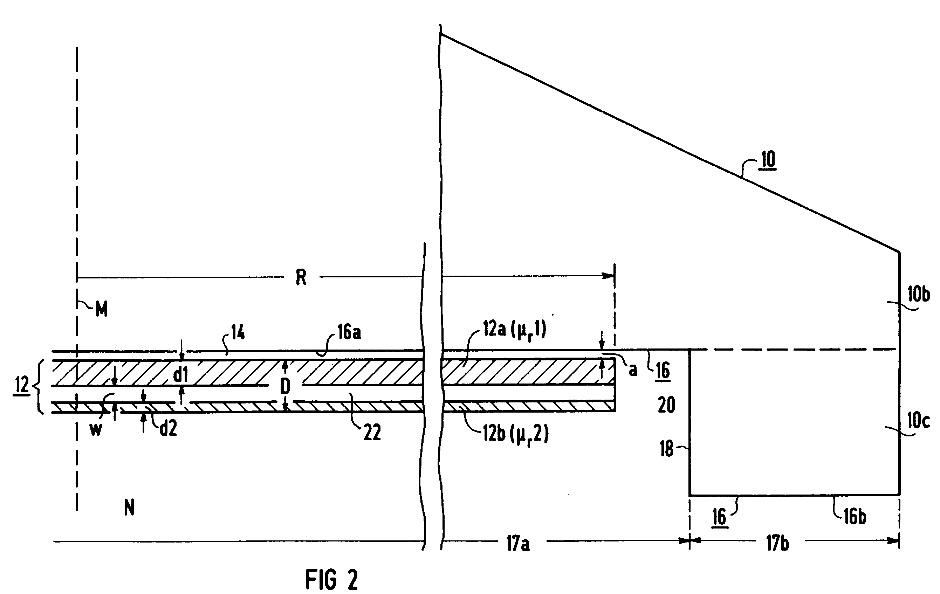

Zur weiteren Erläuterung der Erfindung wird nachfolgend auf die Zeichnung Bezug genommen, in deren Figur 1 eine prinzipielle Ausführungsform eines Homogenfeldmagneten angedeutet ist. Figur 2 gibt einen vergrößerten Ausschnitt aus einem erfindungsgemäß gestalteten Polschuh dieses Magneten wieder. In den Figuren sind übereinstimmende Teile mit denselben Bezugszeichen versehen.

Bei einem erfindungsgemäßen Homogenfeldmagneten wird von bekannten Ausführungsformen ausgegangen, wie sie sich insbesondere für die Kernspintomographie vorsehen lassen (vgl. z.B. die genannte EP-A oder die DE-OS 37 37 133). Nicht näher erläuterte Teile des Magneten entsprechen deshalb denen dieser bekannten Ausführungsformen.

Der aus dem schematischen Längsschnitt der Figur 1 ersichtliche Homogenfeldmagnet ist allgemein mit 2 bezeichnet. Er weist ein einschenkliges magnetisches Joch 3 z.B. aus Eisen in Form eines "C" auf. Die beiden gegenüberliegenden, freien Schenkelenden 3a bz. 3b des Joches 3 münden jeweils in einen wenigstens annähernd zylinderförmigen Kern 4 bzw. 5 aus ferromagnetischem Material. Diese aufeinander zuführenden Kerne sind dabei jeweils von einer eigenen Erregerspule 7 bzw. 8 umschlossen. An den den Schenkelenden 3a bzw. 3b abgewandten Seiten gehen die beiden Kerne 4 und 5 jeweils in einen sich verbreiternden Polschuh 10 bzw. 11 über. Es ergibt sich so ein zu einer Symmetrieebene E zumindest weitgehend symmetrischer Aufbau des gesamten Magneten 2.

Zwischen den um einen Abstand A beabstandeten Polflächen 10a und 11a der beiden Polschuhe 10 bzw. 11 ist ein Zwischenraum oder Nutzvolumen N ausgebildet. In diesem Nutzvolumen soll ein zur Kernspintomographie hinreichend homogenes Magnetfeld mit einer magnetischen Induktion $B_0$ herrschen, das von den beiden Erregerspulen 7 und 8 hervorgerufen wird.

Jeder der Polschuhe 10 und 11 enthält einen magnetflußführenden Basisteil 10b bzw. 11b, der über den jeweiligen Kern 4 oder 5 mit dem Joch 3 verbunden ist. Jeder Basisteil 10b bzw. 11b hat eine freie, bis auf einen Randbereich praktisch ebene Fläche und weist in dem Randbereich ein den gegenseitigen Abstand A verringerndes wulstartiges Randstück 10c bzw. 11c auf. Diese ringförmigen Randstücke dienen zur Feldkorrektur. In jedem von diesen Randstücken umgrenzten inneren, zentralen Bereich der Polschuhe ist eine besondere, erfindungsgemäß gestaltete Polplatteneinrichtung 12 bzw. 13 angeordnet. Jede dieser Polplatteneinrichtungen 12 und 13 soll dabei von dem jeweils zugeordneten Basisteil 10b bzw. 11b durch einen schmalen, axialen Korrekturluftspalt 14 bzw. 15 beabstandet sein. Ferner befinden sich in der Figur nicht dargestellten Gradientenspulen zur Erzeugung von zur Kernspintomographie erforderlichen gepulsten Gradientenfeldern im allgemeinen in unmittelbarer Nähe der dem Nutzvolumen N zugewandten Oberflächen 10a und 11a der Polplatteneinrichtungen 12 und 13.

Die erfindungsgemäße Ausgestaltung der Polplatteneinrichtungen geht aus dem in Figur 2 gezeigten schematischen Längsschnitt hervor. In dieser Figur ist ein vergrößerter Ausschnitt aus einem Teil eines der beiden Polschuhe des Magneten 2 nach Figur 1, beispielsweise des Polschuhs 10 dargestellt. Entsprechende Gestaltungsmerkmale sollen auch für den Polschuh 11 vorgesehen werden.

Aus dem in Figur 2 gezeigten Schnitt durch einen zu einer Mittellinie M rotationssymmetrischen Teil des Polschuhs 10 ist der eine weitgehend trapezförmige Schnittfläche aufweisende Basisteil 10b mit einer gestuften Oberfläche 16 ersichtlich. Diese Oberfläche ist in einen mittleren Oberflächenteil 16a eines mittleren, zentralen Polbereichs 17a und in einen äußeren Oberflächenteil 16b eines Randbereichs 17b unterteilt. Zwischen diesen beiden Bereichen ist eine Stufe 18 ausgebildet, so daß sich ein Randstück 10c des Basisteils ergibt. Das Randstück kann beispielsweise eine trapezförmige oder auch rechteckige Querschnittsfläche haben. Es kann einstückig mit dem Basisteil 10b ausgebildet oder als ein eigenes Bauteil an den Basisteil angefügt sein. Der Basisteil kann aber auch in anderer Form profiliert sein.

In dem mittleren, zentralen Polbereich 17a ist von dem Oberflächenteil 16a durch einen schmalen axialen Korrekturluftspalt 14 der Weite a getrennt die Polplatteneinrichtung 12 angeordnet. Dabei soll zwischen dem Außenrand der Polplatteneinrichtung und dem Randstück 10c ein radialer Spalt 20 verbleiben. Stellvorrichtungen zum Fixieren sowie zum Kippen und/oder Biegen der Polplatteneinrichtung 12 sind hinlänglich bekannt (vgl. z.B. die genannte DE-OS 37 37 133). Sie sind deshalb in der Zeichnung weggelassen.

Die gesamte Polplatteneinrichtung 12 (und entsprechend auch die gesamte Polplatteneinrichtung 13) weist im allgemeinen eine rechteckige Querschnittsfläche auf, wobei sie im Vergleich zu ihrem Radius R verhältnismäßig dünn ausgebildet ist. So liegt ihre konstante Dicke D im allgemeinen zwischen 0,3 und 3 cm, vorzugsweise zwischen 5 und 15 mm. Die Polplatteneinrichtung 12 soll erfindungsgemäß in zwei Polplattenelemente 12a und 12b unterteilt sein, die parallel zueinander ausgerichtet und durch einen Spalt 22 der Weite w beabstandet sind. Dabei soll das dem Basisteil 10b zugewandte Polplattenelement 12a aus einem weichmagnetischen Material bestehen, dessen relative Permeabilität $\mu_r1$ mindestens um einen Faktor 5, vorzugsweise mindestens um einen Faktor 10, geringer ist als die relative Permeabilität $\mu_r2$ des weichmagnetischen Materials, welches für das dem Nutzvolumen N zugewandte Polplattenelement 12b vorgesehen wird. Die relative Permeabilität $\mu_r2$ soll dabei mindestens 10000, vorzugsweise mindestens 50000 betragen. Wie ferner aus Figur 2 zu entnehmen ist, weisen die beiden Polplattenelemente 12a und 12b auch unterschiedliche Dicken d1 bzw. d2 auf, wobei d1 > d2 ist. Die Dicke d1 des Polplattenelementes 12a liegt dabei im allgemeinen zwischen 3 und 25 mm, während für das Polplattenelement 12b im allgemeinen eine Dicke d2 zwischen 1 und 5 mm gewählt wird. Das somit dickere Polplattenelement 12a übernimmt im wesentlichen die Radialflußverteilung des magnetischen Grundfeldes. Es sollte deshalb aus einem Material mit einer hinreichend hohen magnetischen Sättigungsinduktion $B_s$ bestehen. Deshalb sind hierfür vorzugsweise Reineisen ($B_s \approx 1,8$ T) oder Fe-Si-Legierungen mit Si-Gehalten zwischen 2 und 7 Atom-% ($B_s > 1,5$ T) geeignet. Diese Materialien weisen eine relative Permeabilität $\mu_r1$ auf, die im allgemeinen zwischen 1000 und 5000 liegt. Demgegenüber wird der von den Gradientenspulen erzeugte magnetische Gradientenfluß im wesentlichen nur von dem dünneren Polplattenelement 12b aus dem hochpermeablen Material erfaßt. Zur Unterdrückung von Hystereseeffekten sind hierfür Materialien mit besonders geringer magnetischer Koerzitivfeldstärke $H_c$, insbesondere mit $H_c \leq 0,05$ A/cm auszuwählen. Materialien, die diese Anforderungen erfüllen, sind insbesondere spezielle Fe-Ni-Legierungen mit einem Ni-Gehalt zwischen 40 und 85 Atom-%. Beispiele entsprechender Legierungen sind die Materialien mit dem Handelsnamen "MUMETALL" (mit 72 bis 83 Atom-% Ni) und "PERMENORM 5000" (mit 45 bis 50 Atom-% Ni) der Firma "Vacuumschmelze GmbH", Hanau, DE (vgl. auch das Buch dieser Firma "Weichmagnetische Werkstoffe", 4. Auflage, 1990, Seiten 278 und 279).

Wesentlich für den erfindungsgemäßen Homogenmagneten ist eine ausreichende Weite w des Spaltes 22, um eine hinreichende magnetische Entkopplung zwischen den beiden Polplattenelementen 12a und 12b zu gewährleisten. Andernfalls würde nämlich radialer magnetischer Fluß aus dem Polplattenelement 12a in das hochpermeable Polplattenelement 12b übertreten und dieses magnetisch sättigen. D.h., es muß eine Sättigung des hochpermeablen Materials des Polplattenelements 12b aufgrund einer von dem Polplattenelement 12a verursachten magnetischen Feldstärke H verhindert werden, also ein magnetischer Kurzschluß vermieden werden. Die Quelle der Feldstärke H kann dabei der radiale magnetische Fluß in dem Polplattenelement 12a oder die Koerzitivfeldstärke $H_c$ dessen Materials sein. Durch Aufsummieren des vom Polplattenelement 12a in das Polplattenelement 12b übertretenden magnetischen Flusses unter Annahme der Bedingung $\int H\,ds = 0$ kann dann für die in das Polplattenelement 12b übertretende radiale magnetische Flußdichte folgende Abschätzung vorgesehen werden:

$$B' = \mu_0 * H_c * R^2/(8 * w * d2)$$

Hierbei ist B' die in dem Polplattenelement 12b hervorgerufene magnetische Induktion. B' sollte dabei höchstens etwa 1/5 bis 2/3, vorzugsweise 1/3 bis 1/2 der Sättigungsinduktion $B_s'$ des Materials dieses Polplattenelements betragen. $H_c$ ist die Koerzitivfeldstärke des Materials des Polplattenelements 12a. $\mu_0$ ist die universelle magnetische Feldkonstante.

Aus der vorstehenden Abschätzung ergibt sich dann unter Zugrundelegung der erfindungsgemäß vorgesehenen Materialien und von üblichen Abmessungen der Polplattenelemente 12a und 12b für die Spaltweite w:

$$1 \text{ mm} \leq w \leq 6 \text{ mm}.$$

<u>Ausführungsbeispiel</u>

R   der Polplattenelemente 12a und 12b: 0,4 m

$H_c$   von FeSi(3 Atom-%)-Legierung des Polplattenelements 12a: 0,5 A/cm

d2   des Polplattenelements 12b: 2 mm

B'   von FeNi(72-83 Atom-%, Zusätze von Cu, Mo. u. a.)-Legierung (beispielsweise "MUMETALL") des Polplattenelements 12b: 0,2 T ($\approx (1/4) * B_s'$)

Dann ergibt sich für Spaltweite w $\approx$ 4 mm.

Das Polplattenelement 12b kann dabei einen magnetischen Fluß von $4 * 10^{-4}$ Vs/m tragen, der durch einen magnetischen Feldgradienten von 10 mT/m erzeugt wird.

Der Spalt 22 zwischen den Polplattenelementen 12a und 12b kann vorteilhaft durch eine Platte aus Kunststoff oder aus einem nicht-magnetischen Metall wie z.B. Aluminium oder Kupfer ausgefüllt werden. Aus dem Plattenstapel aus den Elementen 12a, 12b und der den Spalt 22 ausfüllenden Platte wird dann z.B. durch Verkleben oder durch eine Vielzahl dünner unmagnetischer Schrauben ein kompaktes handhabbares Bauteil als Polplatteneinrichtung 12 gebildet.

Abweichend von der aus den Figuren ersichtlichen Ausführungsform eines erfindungsgemäßen Homogenfeldmagneten kann dieser auch eine andere Gestalt, z. B. in Form eines "H", haben. Ferner können seine Polplattenelemente selbstverständlich auch lamelliert sein. Darüber hinaus braucht die Weite a der Korrekturluftspalte 14 und 15 in radialer Richtung gesehen nicht konstant zu sein (vgl. die genannte EP-A).

**Patentansprüche**

1. Homogenfeldmagnet mit einem den magnetischen Fluß führenden Joch und zwei gegenüberliegenden Polschuhen, zwischen denen ein Nutzvolumen mit einem Magnetfeld hoher Homogenität ausgebildet ist, wobei jeder Polschuh mit einer Polplatteneinrichtung versehen ist, welche gegenüber einem dem Joch zugewandten Basisteil des jeweiligen Polschuhs über einen schmalen Korrekturluftspalt beabstandet ist und wenigstens zwei untereinander parallele Polplattenelemente aus unterschiedlichen Materialien enthält, **dadurch gekennzeichnet,** daß die Polplattenelemente (12a, 12b) gegenseitig durch einen Spalt (22) vorbestimmter Weite (w) beabstandet sind und daß an jedem Polschuh (10, 11) das dem Basisteil (10b, llb) zugewandte Polplattenelement (12a) aus einem Material besteht, dessen relative Permeabilität ($\mu_r1$) mindestens um einen Faktor 5 geringer ist als die relative Permeabilität ($\mu_r2$) des Materials des dem Nutzvolumen (N) zugewandten Polplattenelements (12b), die mindestens 10000 beträgt.

2. Magnet nach Anspruch 1, **dadurch gekennzeichnet,** daß die relative Permeabilität ($\mu_r1$) des Materials der dem jeweiligen Basisteil (10b, llb) zugewandten Polplattenelemente (12a) mindestens um einen Faktor 10 geringer ist als die relative Permeabilität ($\mu_r2$) des Materials der dem Nutzvolumen (N) zugewandten Polplattenelemente (12b).

3. Magnet nach Anspruch 1 oder 2, **dadurch gekennzeichnet,** daß das Material der dem Nutzvolumen (N) zugewandten Polplattenelemente (12b) eine relative Permeabilität ($\mu_r2$) von mindestens 50000 hat.

4. Magnet nach einem der Ansprüche 1 bis 3, **dadurch gekennzeichnet**, daß die Polplattenelemente (12a, 12b) jedes Polschuhs (10, 11) unterschiedliche Dicken (dl, d2) aufweisen.

5. Magnet nach Anspruch 4, **dadurch gekennzeichnet,** daß die Dicke (d1) der dem jeweiligen Basisteil (10b, 11b) zugewandten Polplattenelemente (12a) jeweils zwischen 3 und 25 mm liegt.

6. Magnet nach Anspruch 4 oder 5, **dadurch gekennzeichnet,** daß die Dicke (d2) der dem Nutzvolumen (N) zugewandten Polplattenelemente (12b) jeweils zwischen 1 und 5 mm liegt.

7. Magnet nach einem der Ansprüche 1 bis 6, **dadurch gekennzeichnet,** daß der Spalt (22) eine Weite (w) zwischen 1 und 6 mm hat.

8. Magnet nach einem der Ansprüche 1 bis 7, **dadurch gekennzeichnet,** daß der Spalt (22) durch ein nicht-magnetisches Material ausgefüllt ist.

9. Magnet nach einem der Ansprüche 1 bis 8, **dadurch gekennzeichnet,** daß die dem jeweiligen Basisteil (10b, 11b) zugewandten Polplattenelemente (12a) aus einer Fe-Si-Legierung mit einem Si-Gehalt zwischen 2 und 7 Atom-% bestehen.

10. Magnet nach einem der Ansprüche 1 bis 9, **dadurch gekennzeichnet,** daß die dem Nutzvolumen (N) zugewandten Polplattenelemente (12b) aus einer Fe-Ni-Legierung mit einem Ni-Gehalt zwischen 40 und 85 Atom-% bestehen.

**Claims**

1. A homogeneous field magnet having a yoke which conducts the magnetic flux and two opposed pole shoes between which a useful space containing a magnetic field of high homogeneity is formed, each pole shoe being provided with a pole plate device which is spaced from a base part, facing towards the yoke, of the respective pole shoe via a narrow correction air gap and comprising at least two pole plate elements parallel to one another which are composed of different materials, characterised in that the pole plate elements (12a, 12b) are spaced from one another by a gap (22) of a predetermined width (w) and that in the case of each pole shoe (10, 11) the pole plate element (12a) facing towards the base part (10b, 11b) is composed of a material whose relative permeability ($\mu_r1$) is at least a factor of 5 lower than the relative permeability ($\mu_r2$) of the material of the pole plate element (12b) facing towards the useful space (N) which amounts to at least 10,000.

2. A magnet according to Claim 1, characterised in that the relative permeability ($\mu_r1$) of the material of the pole plate elements (12a) facing towards the respective base part (10b, 11b) is at least a factor of 10 lower than the relative permeability ($\mu_r2$) of the material of the pole plate elements (12b) facing towards the useful space (N).

3. A magnet according to Claim 1 or 2, characterised in that the material of the pole plate elements (12b) facing towards the useful space (N) has a relative permeability ($\mu_r2$) of at least 50,000.

4. A magnet according to one of Claims 1 to 3, characterised in that the pole plate elements (12a, 12b) of each pole shoe (10, 11) have different thicknesses (d1, d2).

5. A magnet according to Claim 4, characterised in that the thickness (d1) of the pole plate elements (12a) facing towards the respective base part (10b, 11b) is in each case between 3 and 25 mm.

6. A magnet according to Claim 4 or 5, characterised in that the thickness (d2) of the pole plate elements (12b) facing towards the useful space (N) is in each case between 1 and 5 mm.

7. A magnet according to one of Claims 1 to 6, characterised in that the gap (22) has a width (w) of between 1 and 6 mm.

8. A magnet according to one of Claims 1 to 7, characterised in that the gap (22) is filled with a nonmagnetic material.

9. A magnet according to one of Claims 1 to 8, characterised in that the pole plate elements (12a) facing towards the respective base part (10b, 11b) consist of a Fe-Si alloy with a Si-content of between 2 and 7 atom %.

10. A magnet according to one of Claims 1 to 9, characterised in that the pole plate elements (12b) facing towards the useful space (N) consist of a Fe-Ni alloy with a Ni content of between 40 and 85 atom %.

**Revendications**

1. Aimant pour champ homogène avec une culasse dirigeant le flux magnétique et avec deux pièces polaires se faisant face, entre lesquelles un volume utile avec un champ magnétique d'homogénéité élevée est constitué, chaque pièce polaire étant munie d'un arrangement de disques polaires lequel est séparé d'une pièce de base de la pièce polaire respective, tournée vers la culasse via une fente de correction étroite et contient au moins deux éléments de disque polaire parallèles entre eux, de matériaux différents, caractérisé en ce que les éléments de disque polaire (12a, 12b) sont situés à distance l'un de l'autre par une fente (22) de largeur prédéterminée (w) et en ce que, à chaque pièce polaire (10, 11), l'élément de disque polaire (12a) tourné vers la pièce de base (10b, 11b) est constitué d'un matériau dont la perméabilité relative ($\mu_r1$) est inférieure au moins d'un facteur 5 à la perméabilité relative ($\mu_r2$) du matériau de l'élément de disque polaire (12b) tourné vers le volume utile (N), qui s'élève à au moins 10000.

2. Aimant selon la revendication 1, caractérisé en ce que la perméabilité relative ($\mu_r1$) du matériau des éléments de disque polaire (12a) tournés vers la pièce de base (10b, 11b) correspondante est inférieure au moins d'un facteur 10 à la perméabilité relative ($\mu_r2$) du matériau des éléments de disque polaire (12b) tournés vers le volume utile (N).

3. Aimant selon la revendication 1 ou 2, caractérisé en ce que le matériau des éléments de disque polaire (12b) tournés vers le volume utile (N) a une perméabilité relative ($\mu_r2$) d'au moins 50000.

4. Aimant selon l'une des revendications 1 à 3, caractérisé en ce que les éléments de disque polaire (12a, 12b) de chaque pièce polaire (10, 11) présentent des épaisseurs différentes (d1, d2).

5. Aimant selon la revendication 4, caractérisé en ce que l'épaisseur (d1) des éléments de disque polaire (12a) tournés vers la pièce de base correspondante (10b, 11b) se situe respectivement entre 3 et 25 mm.

6. Aimant selon la revendication 4 ou 5, caractérisé en ce que l'épaisseur (d2) des éléments de disque polaire (12b) tournés vers le volume utile (N) se situe respectivement entre 1 et 5 mm.

7. Aimant selon l'une quelconque des revendications 1 à 6, caractérisé en ce que la fente (22) a une largeur (w) entre 1 et 6 mm.

8. Aimant selon l'une quelconque des revendications 1 à 7, caractérisé en ce que la fente (22) est comblée par un matériau non-magnétique.

9. Aimant selon l'une quelconque des revendications 1 à 8, caractérisé en ce que les éléments de disque polaire (12a) tournés vers la pièce de base correspondante (10b, 11b) sont constitués d'un alliage Fe-Si avec une teneur en Si entre 2 et 7 % atomiques.

10. Aimant selon l'une quelconque des revendications 1 à 9. caractérisé en ce que les éléments de disque polaire (12b) tournés vers le volume utile (N) sont constitués d'un alliage Fe-Ni avec une teneur en Ni entre 40 et 85 % atomiques.

FIG 1

FIG 2

EP 0 616 230 B1